# EUROPEAN PATENT APPLICATION

(11) **EP 1 535 879 A1**
(43) Date of publication of application: **01.06.2005**
(21) Application number: 03760931.0
(22) Date of filing: 20.06.2003
(51) Int. Cl.: B81B 7/04, B81C 1/00, H01L 27/04

(54) **MEMS ARRAY, MANUFACTURING METHOD THEREOF, AND MEMS DEVICE MANUFACTURING METHOD BASED ON THE SAME**

(30) Priority: 21.06.2002 JP 2002181965
(71) Applicant: TOKYO ELECTRON LIMITED, Minato-ku, Tokyo 107-8481 (JP)
(72) Inventor: YUASA, Mitsuhiro; C/O TOKYO ELECTRON LIMITED, Minato-ku, Tokyo 107-8481 (JP)
(74) Representative: Liesegang, Eva
(86) International application number: PCT/JP2003/007891
(87) International publication number: WO 2004/000719

(57) **Abstract**

A plurality of elements such as a resistor (10), capacitor (20), and coil (30) and switches 41 to 44 for connecting these elements are formed integrally on a substrate 1 and the elements are made freely connectable to form a MEMS array. The switches 41 to 44 used may be transistor switches or mechanical switches. It is possible to produce a MEMS device by replacing the on/off states of the switches 41 to 44 of the MEMS array with short-circuited/open states of the interconnects.

## Description

### TECHNICAL FIELD

The present invention relates to technology utilizing a MEMS (Micro Electro-Mechanical System), more particularly relates to a micromachine and MEMS array provided with a plurality of circuit elements and switches.

### BACKGROUND ART

MEMS's integrally form not only electronic circuits, but also different elements such as sensors and actuators on an Si or other substrate to impart sophisticated functions, so hold the promise of great growth. In the past, as technology for producing MEMS devices, (1) mounting sensors and other individual elements made using MEMS technology on substrates and (2) producing individual specialized MEMS circuits have been known.

In the case of the above (1), however, even if utilizing MEMS for production of individual elements, due to the restrictions at the time of mounting, a great reduction in size is difficult. There are limits to the performance of elements and limits to the reduction of the mounting area. Further, there is also the problem of interconnect delay. Further, in the case of the above (2), since the devices are specialized, an increase in development time and increase in development cost are unavoidable compared with (1).

### DISCLOSURE OF INVENTION

The present invention, in consideration of the above problems, has as its object to provide a programmable MEMS array enabling a reduction of size and enabling the development time and development costs to be slashed and to provide a method of producing a MEMS device using the same.

The present invention achieves this object by providing a MEMS array comprised of a plurality of elements and switches for connecting the elements arranged on a substrate and enabling the elements to be freely connected.

Further, the MEMS array of the present invention is provided with a plurality of elements in at least one layer and provided with the switches in another layer. The switches of the MEMS array of the present invention may be constituted by transistors or may be constituted by mechanical switches.

According to the present invention, it is possible to form a desired circuit by just selecting the on/off states of the switches and thereby possible to meet diverse needs.

Further, according to the present invention, it is possible to produce a MEMS device based on the MEMS array. That is, a MEMS device is produced by the step of determining the connection states of the switches of the MEMS array to form a desired circuit, then interconnecting elements in accordance with the connection states of the switches.

By doing this, it is possible to mass produce MEMS devices able to reduce power for maintaining the connection states of the switches.

### BRIEF DESCRIPTION OF DRAWINGS

The present invention will be explained below while referring to the attached drawings.
FIG. 1 is a cross-sectional view of a cross-section of a first embodiment of a MEMS array,
FIG. 2 is a view of the appearance of a first embodiment of a MEMS array,
FIG. 3 is a view of an equivalent circuit of a first embodiment of a MEMS array,
FIG. 4 is a cross-sectional view along the line A-A of FIG. 1 and a plan view of the arrangement of sources and drains of switches of a first embodiment of a MEMS array,
FIG. 5 is a cross-sectional view along the line B-B of FIG. 1 and a plan view of the interconnections of an M1 layer of a first embodiment of a MEMS array,
FIG. 6 is a cross-sectional view along the line C-C of FIG. 1 and a plan view of the interconnections of an M3 layer of a first embodiment of a MEMS array,
FIG. 7 is a view of an example of the on/off states of switches of a first embodiment of a MEMS array,
FIG. 8 is a view of an example of a MEMS device as a static circuit produced using a MEMS array,
FIG. 9 is a view of an example of a MEMS device as a dynamic circuit produced using a MEMS array,
FIG. 10 is a view of a second embodiment of a MEMS array,
FIG. 11 is a view of a step (a) of a second embodiment of a MEMS array showing a step up to an LSI part,
FIG. 12 is a view of a step (b) of a second embodiment of a MEMS array showing a step of forming an insulating film,
FIG. 13 is a view of a step (c) of a second embodiment of a MEMS array showing a step before forming a capacitor bottom electrode and vias,
FIG. 14 is a view of a step (d) of a second embodiment of a MEMS array showing a step of forming a capacitor bottom electrode and vias,
FIG. 15 is a view of a step (e) of a second embodiment of a MEMS array showing a step of forming an insulating film,
FIG. 16 is a view of a step (f) of a second embodiment of a MEMS array showing a step before forming vias,
FIG. 17 is a view of a step (g) of a second embodiment of a MEMS array showing a step of forming vias,
FIG. 18 is a view of a step (h) of a second embodiment of a MEMS array showing a step before forming a capacitor, top electrode, and coil,
FIG. 19 is a view of a step (i) of a second embodiment of a MEMS array showing a step of forming a capacitor, top electrode, and coil,
FIG. 20 is a view of a step (j) of a second embodiment of a MEMS array showing a step of forming an insulating film,
FIG. 21 is a view of a step (k) of a second embodiment of a MEMS array showing a step before forming vias,
FIG. 22 is a view of a step (l) of a second embodiment of a MEMS array showing a step of forming vias,
FIG. 23 is a view of a step (m) of a second embodiment of a MEMS array showing a step of forming an insulating film,
FIG. 24 is a view of a step (n) of a second embodiment of a MEMS array showing a step before forming element input/output parts and switch drive electrodes,
FIG. 25 is a view of a step (o) of a second embodiment of a MEMS array showing a step of forming element input/output parts and switch drive electrodes,
FIG. 26 is a view of a step (p) of a second embodiment of a MEMS array showing a step of forming a Cu cap layer,
FIG. 27 is a view of a step (q) of a second embodiment of a MEMS array showing a step before forming a resistance thin film,
FIG. 28 is a view of a step (r) of a second embodiment of a MEMS array showing a step of forming a resistance thin film,
FIG. 29 is a view of a step (s) of a second embodiment of a MEMS array showing a step of forming a resistance element,
FIG. 30 is a view of a step (t) of a second embodiment of a MEMS array showing a step of forming a passivation film,
FIG. 31 is a view of a step (u) of a second embodiment of a MEMS array showing a step of etching switch tops,
FIG. 32 is a view of a step (v) of a second embodiment of a MEMS array showing a step of etching switch connections,
FIG. 33 is a view of a step (w) of a second embodiment of a MEMS array showing a step of forming switches,
FIG. 34 is a view of a step (x) of a second embodiment of a MEMS array showing a step of releasing switch tops,
FIG. 35 is a view of a step (y) of a second embodiment of a MEMS array showing a step of releasing switch tops, and
FIG. 36 is a view of another example of an electrostatic switch used in a second embodiment of a MEMS array.

### BEST MODE FOR CARRYING OUT THE INVENTION

### (First Embodiment)

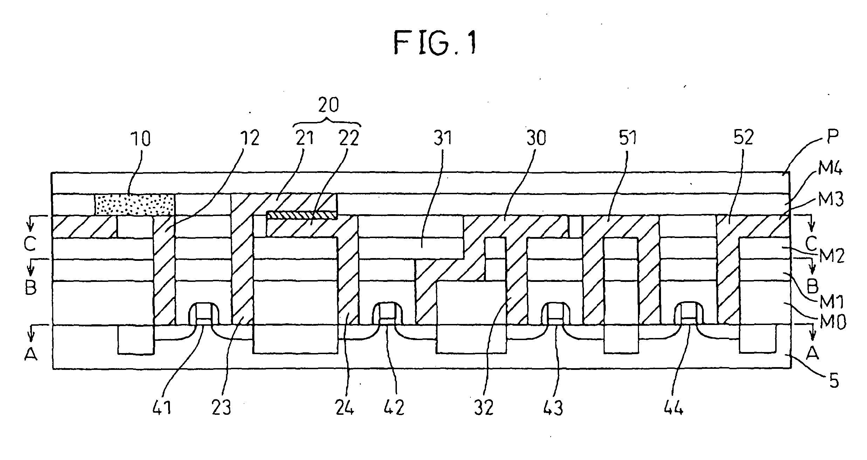

A freely connectable programmable MEMS array of a first embodiment of the present invention will be explained with reference to FIGS. 1 to 6.

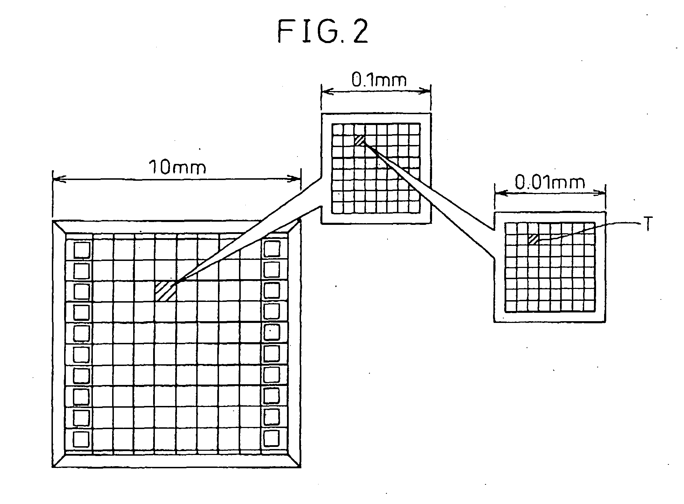

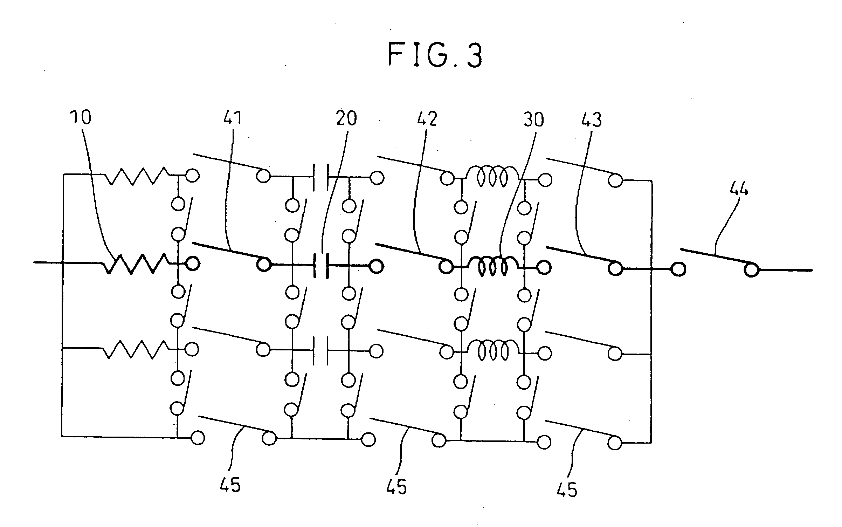

FIG. 1 is a partial cross-sectional view of a freely connectable MEMS array of this embodiment, while FIG. 2 is a schematic view of a MEMS array of the present invention overall. FIG. 3 is a view of an equivalent circuit of this embodiment whose cross-section is shown in FIG. 1.

As seen in the overall schematic view of the MEMS array of FIG. 2, the freely connectable MEMS array of the present invention is comprised of a for example 10 mm² Si chip formed with about 300,000 freely connectable circuit elements utilizing the semiconductor wafer process. As shown in FIG. 3, in this embodiment, a region T of 10 µm square is provided with three LCR circuits forming a single circuit.

The cross-sectional view of FIG. 1 shows a cross-section of the LCR circuit shown by the bold line in the equivalent circuit shown in FIG. 3.

As shown in FIG. 1, the MEMS array of this embodiment is comprised of a substrate S, transistors 41 to 44 with source and drain regions formed on it, interconnect layers M0 to M4 formed over that, and a passivation layer P provided over that. An LCR circuit is comprised a resistor 10, a capacitor 20, a coil 30, and their via interconnects formed in interconnect layers M0 to M1 to be connectable in series by switches 41 to 44 comprised of four transistors (FETs) formed on the substrate S.

Note that in FIG. 1, the interconnects for driving the transistors forming the switches 41 etc. are not shown.

In this embodiment, adjoining elements of the three LCRs can be connected by the large number of switches including the switches 41 to 44. The bottommost part is provided with a switch 45 arranged in parallel with the elements so that the elements can be bypassed. Any combination of the elements is possible.

That is, the MEMS array comprised of the LCR circuits of the present embodiment is comprised of a plurality of resistors, capacitors, and coils regularly arranged in a planar form (two-dimensionally). The elements can be freely connected through switches.

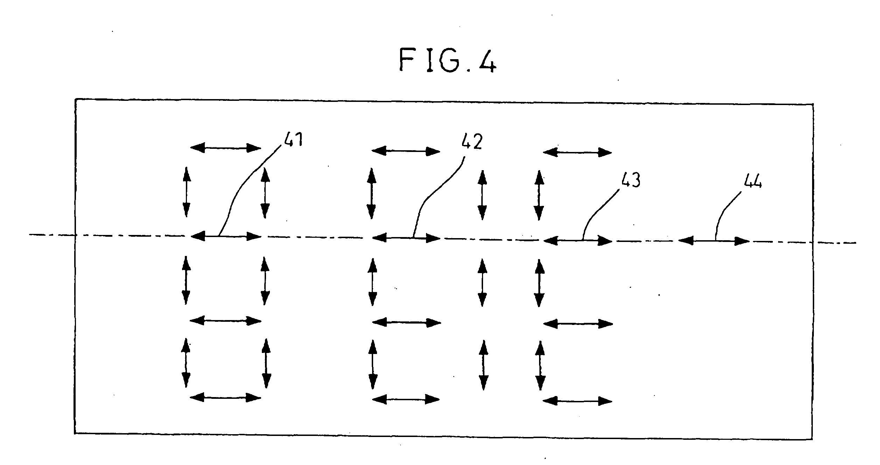

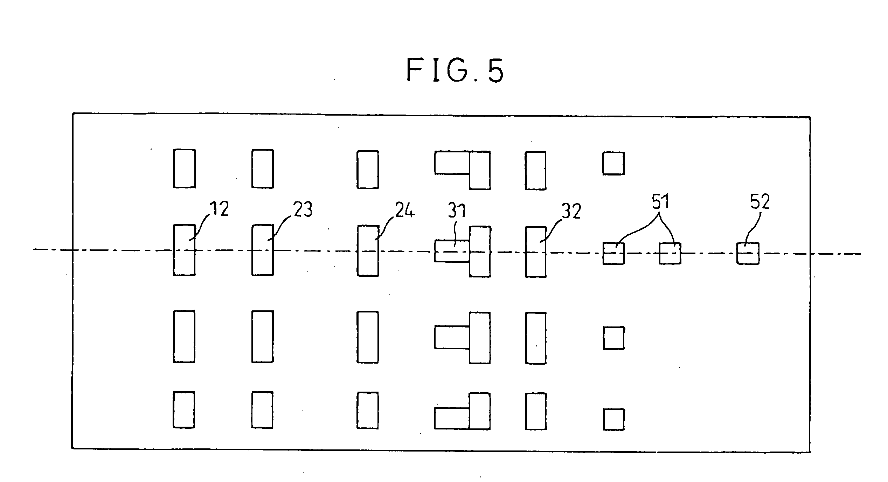

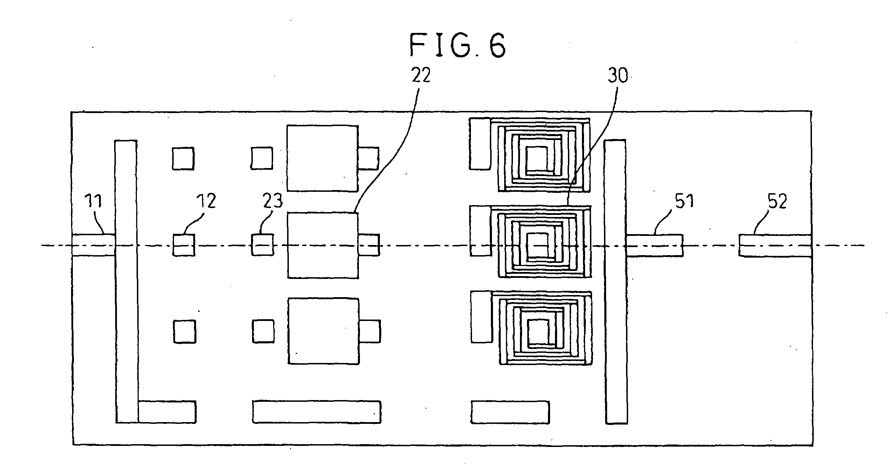

FIG. 4 is a top view of the substrate S cut along the line A-A of FIG. 1, FIG. 5 is a top view of the interconnect layer M1 cut along the line B-B, and FIG. 6 is a top view of the interconnect layer M3 cut long the line C-C.

FIG. 4 shows the general arrangement of the sources and drains of the transistors forming the switches provided on the substrate S. The sources and drains arranged corresponding to the switches 41 to 44 are shown by the same reference numerals.

The interconnect layer M0 is an interconnect layer formed with gate electrodes of transistors and formed with some of the interconnects to the sources and drains. The interconnects (vias) include the interconnect 12 to the resistor 10 for the switch 41, the interconnect 23 to the top electrode 21 of the capacitor 20, the interconnect 24 to the bottom electrode 22 of the capacitor 20 for the switch 42, the interconnects 31 and 32 for the coil 30, and the interconnects 51 and 52 for the switches 43 and 44.

The interconnect layer M1 is shown in FIG. 5 and is provided with one interconnect part 12 of the resistor 10, the interconnect 23 to the top electrode of the capacitor 20, the interconnect 24 to the bottom electrode 22, the interconnects 31 and 32 of the coil 30, and the interconnects 51 and 52 of the switches 43 and 44. The interconnects 12, 23, 24, 31, and 32 also serve as interconnects leading to the switches for parallel connection.

The interconnect layer M2, like the other interconnect layers, is an interconnect layer on which some of the interconnects between the elements and switches are formed. The interconnects are similar to those of the interconnect layer M0, so their explanations will be omitted.

The interconnect layer M3 is shown in FIG. 6 and is provided with interconnect parts 11 and 12 of the resistor 10, the interconnect 23 to the top electrode of the capacitor 20, the bottom electrode 22 of the capacitor 20, the coil 30, and the interconnect parts 51 and 52 to the switches 43 and 44. The interconnects 11 and 51 serve also an interconnects for parallel connection. The interconnect at the bottom end (no reference numeral) is a bypass interconnect.

The interconnect layer M4 is provided with the resistor 10 and provided with the top electrode 21 of the capacitor 20. The topmost part is provided with a passivation layer P.

Note that the configuration of this layer is just an example for explanation. The number of the layers and other aspects of the configuration are not limited. The types of the elements are also not limited to LCRs. The elements need only be ones forming a high frequency filter circuit or other desired electrical or electronic circuit. Their shapes, arrangements, etc. may be suitably selected.

The method of production of the MEMS array of the present embodiment is similar to an Si wafer process and comprises forming a plurality of interconnect layers on a substrate 1 formed with transistor switches. For example, when forming passive elements as well, it is possible to form suitable shapes according to the materials of the conductor layers and otherwise use suitable known wafer processes for production.

In this way, the MEMS array of the present embodiment is comprised of a plurality of circuit elements able to be suitably connected through switches, so by just determining the on/off states of the switches in accordance with the design of the designer, it is possible to freely form a desired circuit.

Next, the method of production of a MEMS device used when using a MEMS array of the present invention to form a circuit, then mass producing a MEMS device will be explained.

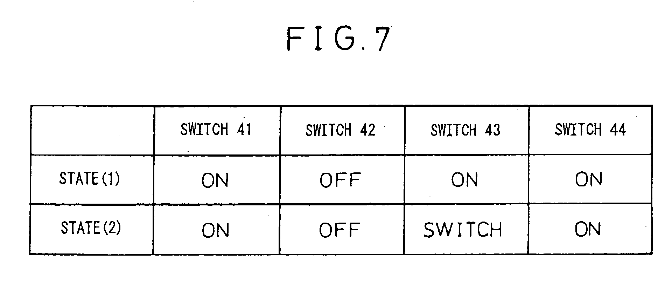

The LCR circuit shown in FIG. 1 will be used as an example. FIG. 7 is a view of the on/off states of the switches 41 to 44 in a circuit formed using the MEMS array of FIG. 1.

That is, FIG. 7 shows the result when using a MEMS array according to the present invention and selecting the on/off states of the switches to form a desired circuit. The state (1) is an example of a static circuit with no switching during circuit operation, while the state (2) is an example of a dynamic circuit with some switching during circuit operation.

In the state (1) of the switches, the switch 41 is on, the switch 42 is off, the switch 43 is on, and the switch 44 is on. This state does not change during the circuit operation. Therefore, the constantly on switches have to be supplied with gate voltage to maintain the on state. This is not economical if considering the power consumption.

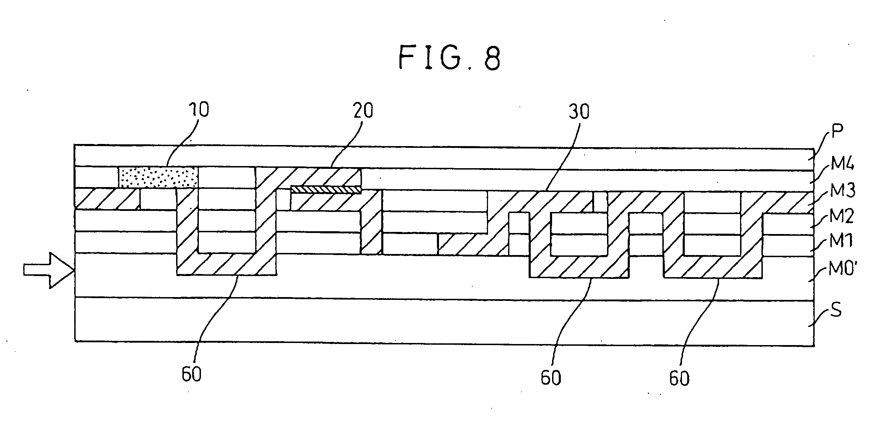

Therefore, as shown in FIG. 8, the substrate S is not formed with any transistor switches. These are replaced by an interconnect layer M0' corresponding to the on/off state of the switches. That is, when the switches 41, 43, and 44 are on, the interconnects 60 are formed for connection (short-circuiting), while when the switch 42 is off, no interconnects are formed (open). By doing this, it is possible to reduce the power and produce a device almost completely free of malfunctions.

Looking at the production process of a MEMS device as well, if adding a single specialized mask, the production process of a MEMS array can be utilized. Further, the step of formation of the transistors can be eliminated and a low cost substrate S can be used, so a mass production device can be made at a low cost.

The state (2) of the switches is the same as the state (1) except for the point that the switch 43 is used as a changeable switch. This differs from the case of the state (1) in that it does not allow all of the switches to be replaced with short-circuit/open states of interconnects.

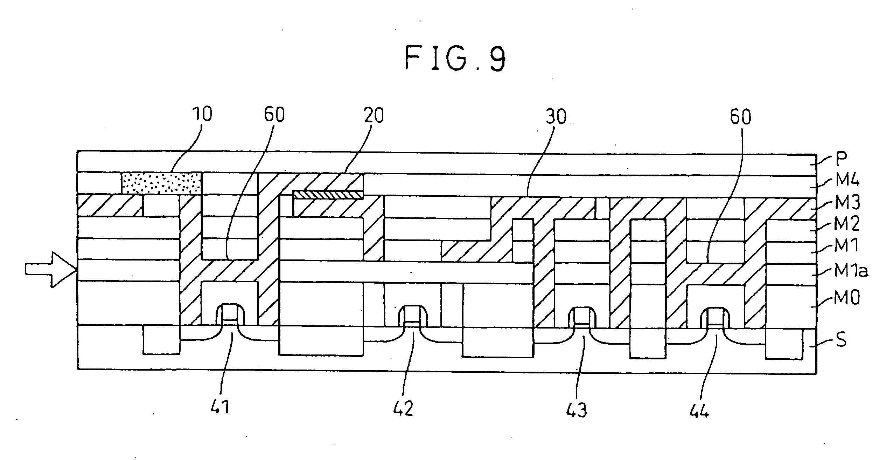

However, as shown in FIG. 9, when adding an interconnect layer M1a above the interconnect layer M0 to maintain the on state as with the switches 41 and 44, the interconnects 60 may be provided to short-circuit the switches 41 and 44 (short-circuiting). When off as in the switch 42, the circuit is broken (open) without forming an interconnect to prevent voltage from being supplied to the gate of the transistor. For the switch 43 for the switching operation, it is sufficient to provide a via to connect the top and bottom so as to maintain the existing interconnect.

By doing this, constantly on transistors do not have to be supplied with voltage for maintaining the on state, so the power consumption can be reduced. Further, in the production process, it is sufficient to add an interconnect layer M1a to the production process of the MEMS array.

### (Second Embodiment)

In the first embodiment, the switches connecting adjoining elements were comprised of transistors, but this embodiment forms these switches by mechanical switches, that is, electrostatic switches. Operating the electrostatic switches requires drive transistors, but mechanical switches do not cause changes in the circuit characteristics when turned on and off compared with transistor switches, so are advantageous when using a MEMS array to form a circuit.

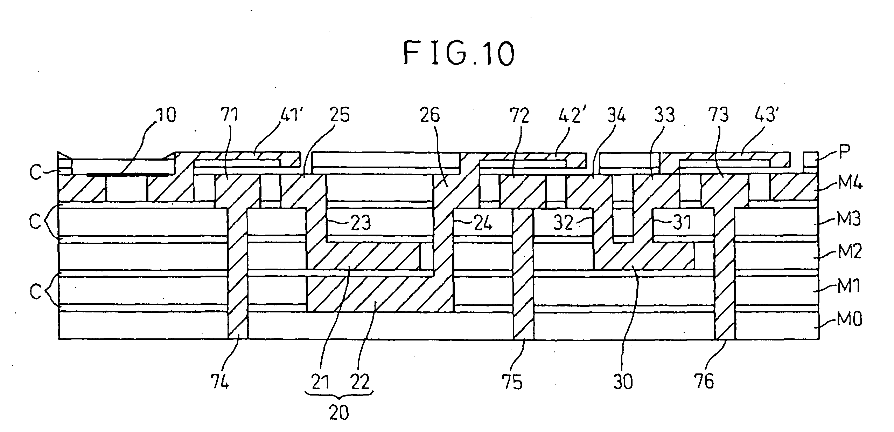

FIG. 10 is a partial cross-sectional view of the part of the MEMS array of the present embodiment omitting the substrate. Components having the same functions as in the first embodiment are assigned the same reference notations.

FIG. 10 shows the interconnect layers M0 to M4 and the passivation layer P on the substrate. Note that the layers are provided between them with Cu cap layers C comprised of silicon nitride etc. These prevent the copper of the interconnect layers from diffusing in the insulating films and causing device defects. The outermost layer is provided with electrostatic switches 41' to 43' having cantilever type movable parts. The switch drive parts 71 to 73 are connected through interconnect vias 74 to 76 to transistors provided on the not shown substrate. The electrostatic switches 41' to 43' close the contacts when the switch drive parts 71 to 73 are given a predetermined voltage and the corresponding movable pieces are attracted. While not shown, a cover may also be provided for protecting the switches and preventing entry of dust.

Further, in the same way as in the first embodiment, q resistor 10, capacitor 20, and coil are formed. The resistor 10, switch 41', capacitor 20, switch 42', coil 30, and switch 43' can be serially connected. These are designed to be connectable to other adjoining elements not shown in the cross-sectional view of FIG. 10 through the switches. The elements can be freely connected.

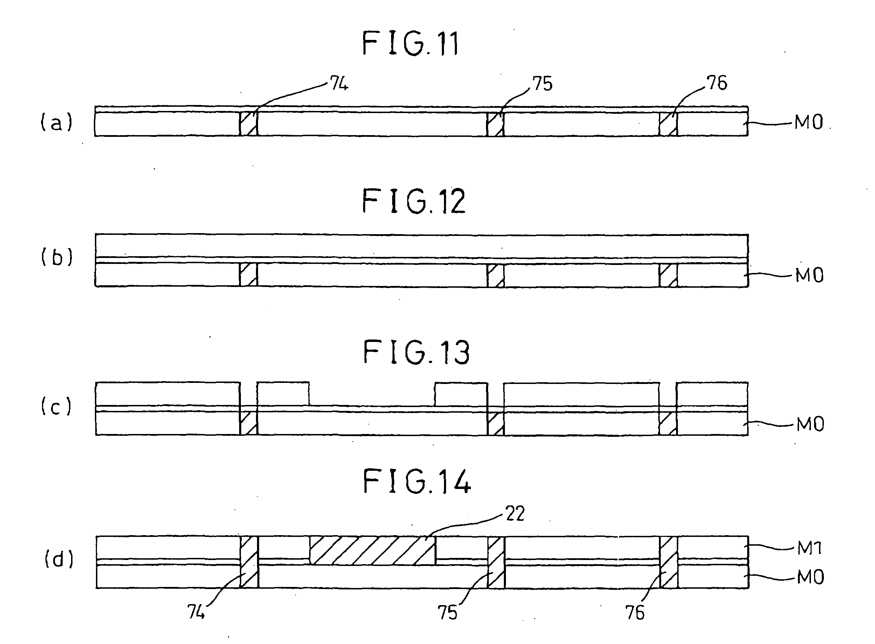

Below, the steps of production will be explained in general with reference to FIGS. 11 to 35. Note that for example there are also steps not explained such as the formation of the Cu cap layers.

First, FIGS. 11 to 14 show steps (a) to (d) up to formation of the interconnect layer M1.

At step (a) of FIG. 11, transistors for driving the static switches are formed on a not shown substrate, then vias 74 to 76 for the interconnects are provided to form the interconnect layer M0.

At step (b) of FIG. 12, an insulating film is formed, at step (c) of FIG. 13, the insulating film is etched for forming the bottom electrode 22 of the capacitor 20 and vias, and at step (d) of FIG. 14, the capacitor bottom electrode is formed and the vias are connected to form the interconnect layer M1.

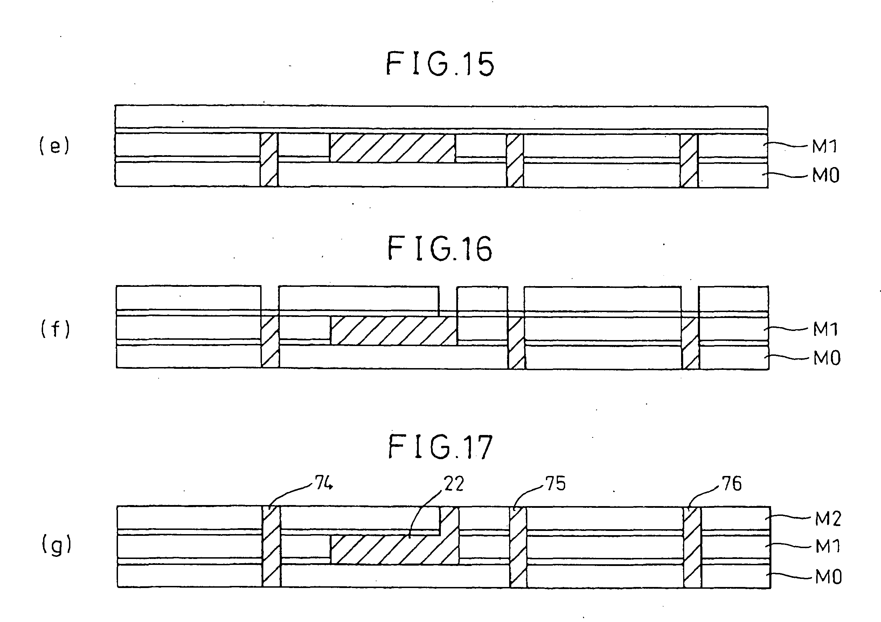

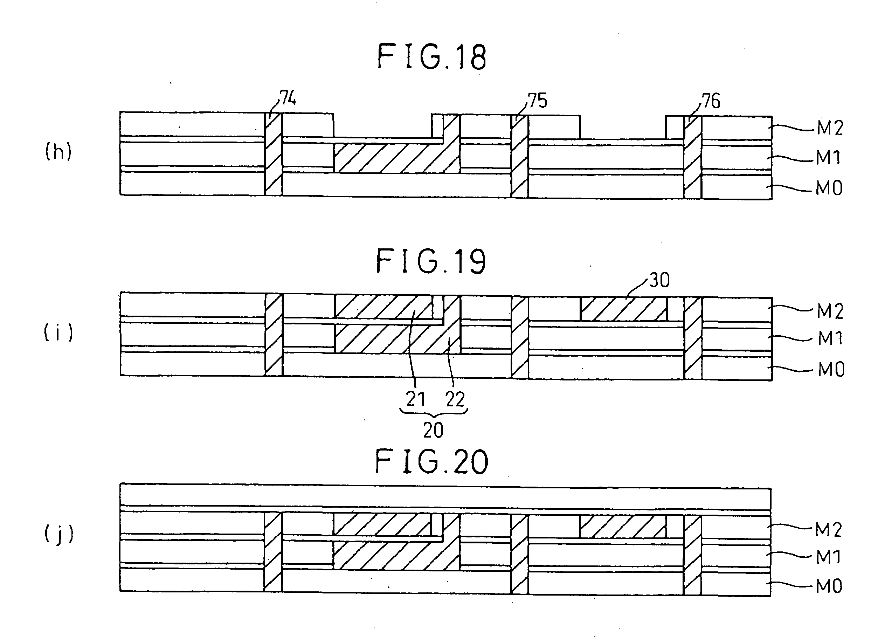

FIGS. 15 to 17 show the steps (e) to (g) up to formation of the vias of the interconnect layer M2. At step (e) of FIG. 15, an insulating film is formed, at step (f) of FIG. 16, the insulating film is etched to form the vias, and at step (g) of FIG. 17 the vias 74 to 76 of the interconnect layer M2 are formed. At step (h) of FIG. 18, the etching before forming the capacitor top electrode and coil of the interconnect layer M2 is shown. This is not formed simultaneously with the vias 74 to 76 of the previous step because it is necessary to leave the Cu cap layer for use as the dielectric of the capacitor. Next, at step (i) of FIG. 19, the capacitor top electrode 21 and coil 30 are formed.

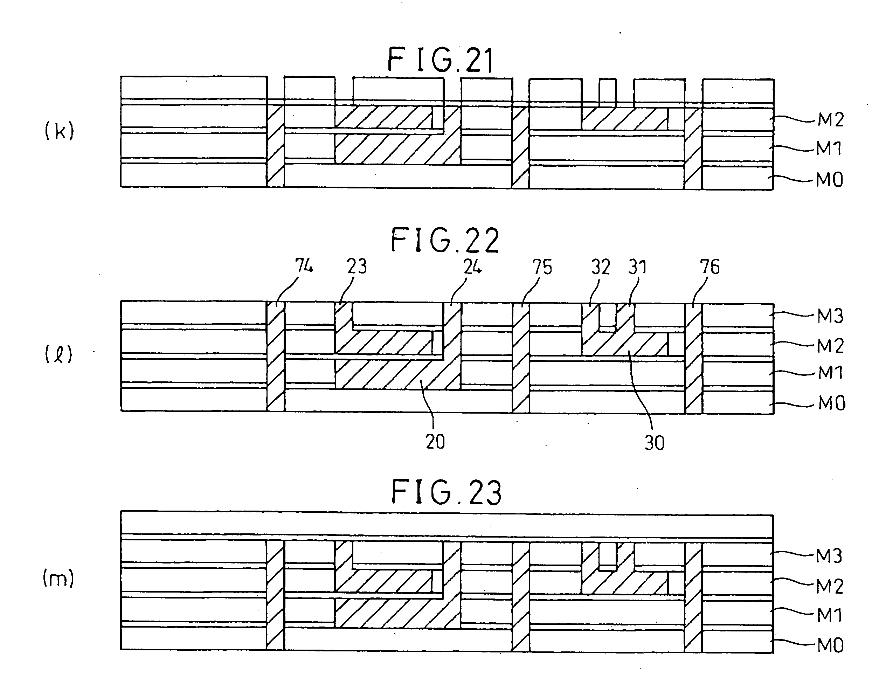

At step (j) shown in FIG. 20 and steps (k) and (l) shown in FIGS. 21 and 22, the via interconnects of the interconnect layer M3 are formed. In the interconnect layer M3, along with the switch drive interconnects 74 to 76, interconnects 23 and 24 to the capacitor 20 and interconnects 31 and 32 to the coil 30 are formed.

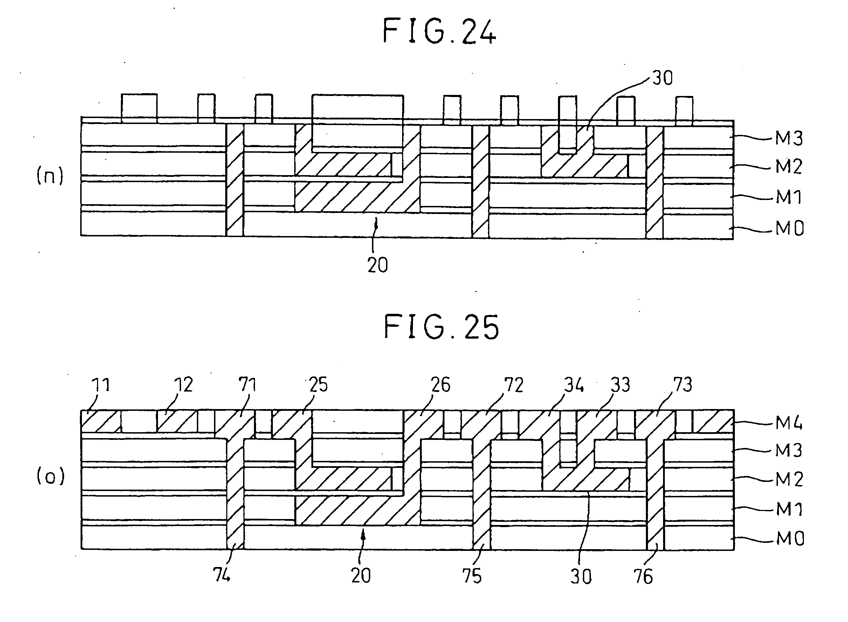

At step (m) shown in FIG. 23 and steps (n) and (o) shown in FIGS. 24 and 25, the interconnect layer M4 is formed. That is, at step (m) of FIG. 23, an insulating film is formed, at step (n) of FIG. 24, the input/output parts of the resistor 10 (FIG. 10), capacitor 20, and coil 30 and the parts for forming the switch drive electrodes are etched, and at step (o) of FIG. 25, the input/output parts 11 and 12 of the resistor 10 (FIG. 10), the input/output parts 25 and 26 of the capacitor 20, the input/output parts 33 and 34 of the coil 30, the switch drive electrodes 71 to 73, etc. are formed.

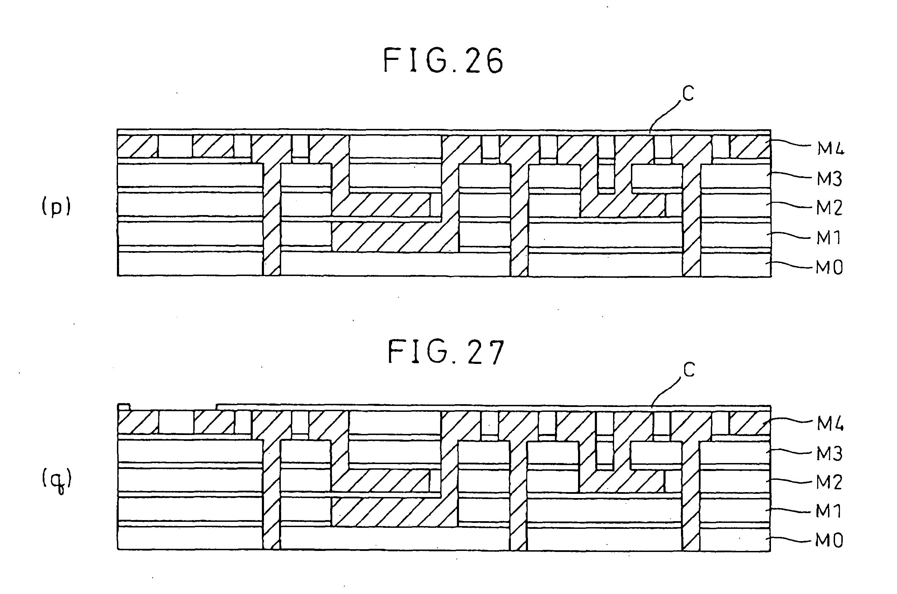

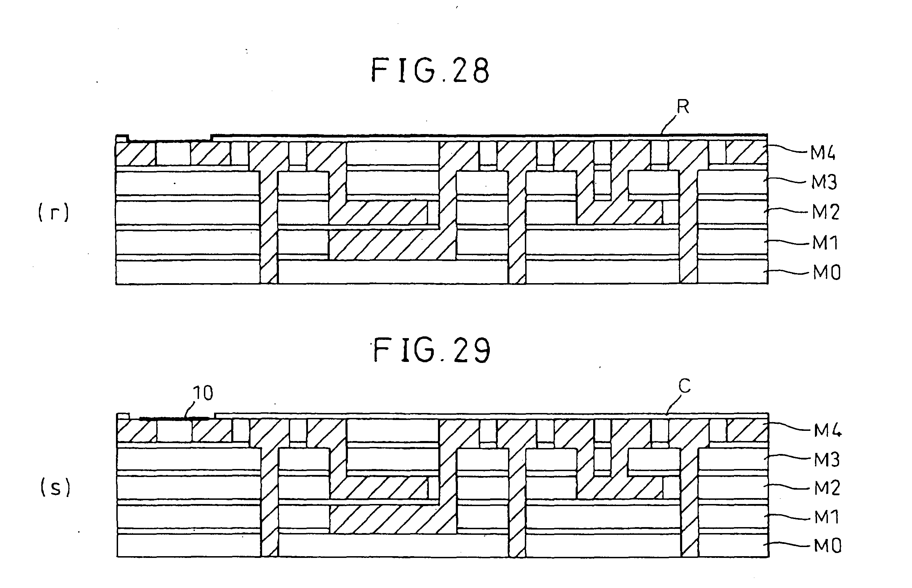

FIGS. 26 to 29 show the steps of formation of the resistor 10. First, at step (p) of FIG. 26, a Cu cap layer C is formed. At step (q) of FIG. 27, the Cu cap layer C is etched to form a resistance thin film forming part. At step (r) of FIG. 28, a resistance thin film R is formed over the entire surface. At step (s) of FIG. 29, the film is etched leaving only the part for use as the resistor to thereby form the resistor 10.

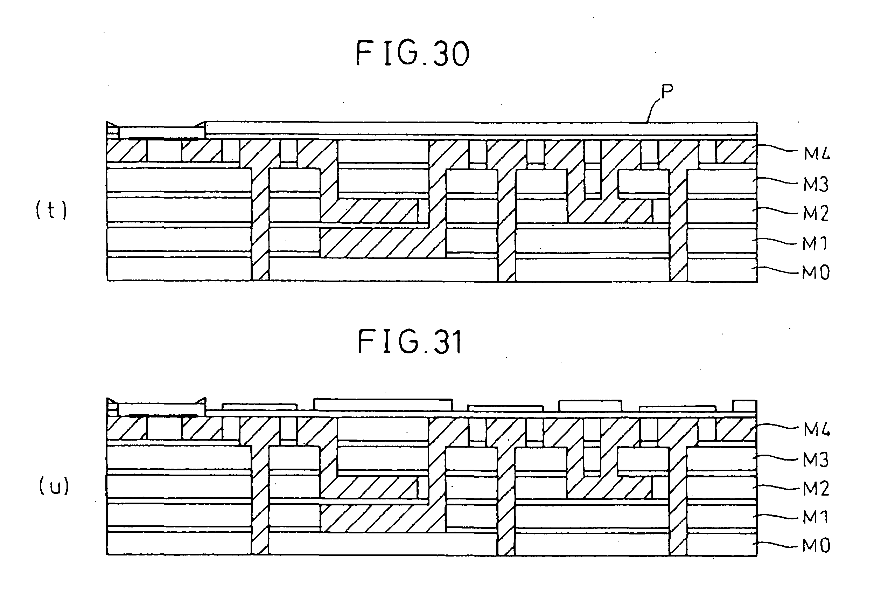

FIGS. 30 to 35 show steps of forming switches from the formation of the protective passivation film P.

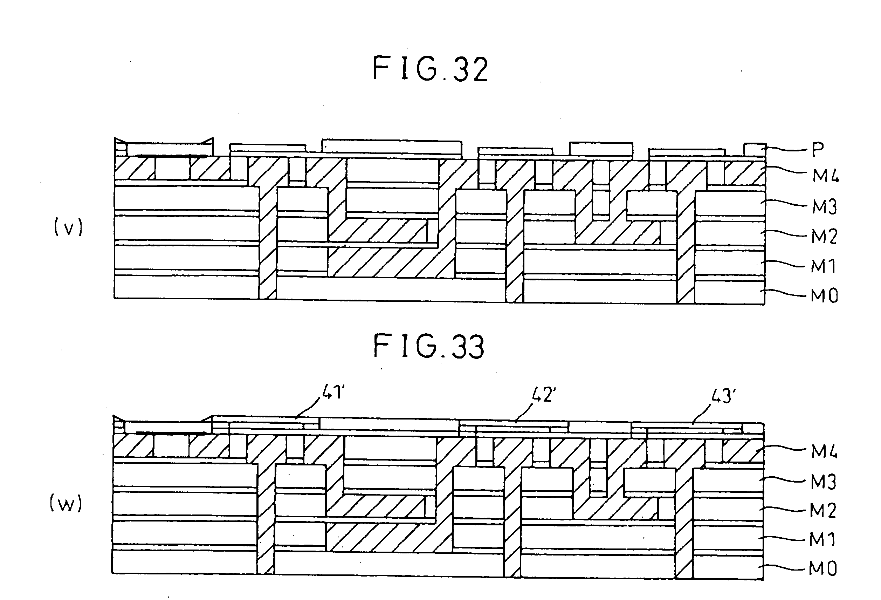

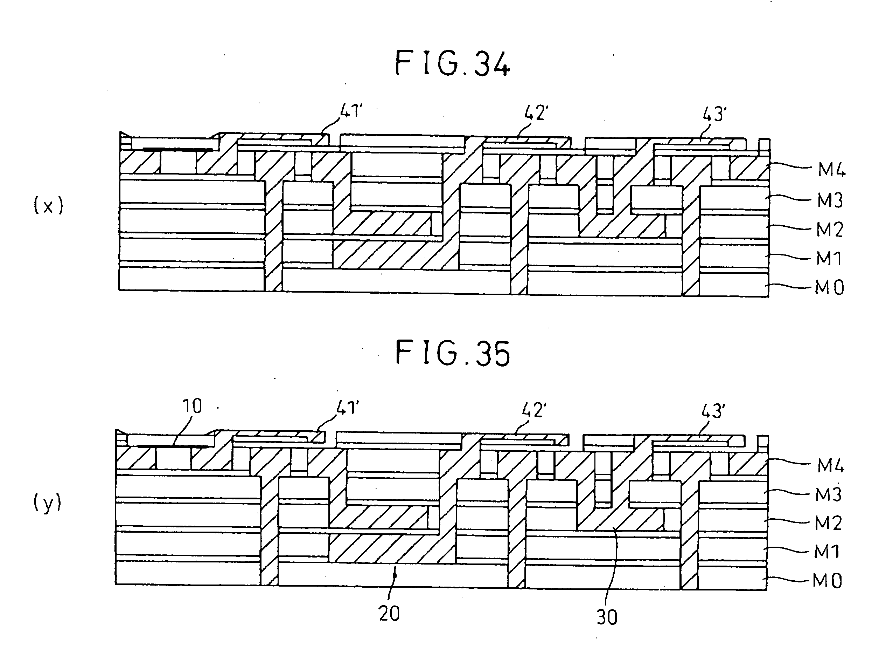

At step (t) of FIG. 30, a protective passivation film P is formed over the entire surface. At step (u) of FIG. 31, this is etched to provide the tops of the switches 41' to 43'. At step (v) of FIG. 32, the surface is further etched for providing the connections of the switches 41' to 43'. Next, at step (w) of FIG. 33, the switches are made, at step (x) of FIG. 34, the tops of the switches 41' to 43' are released, and at step (y) of FIG. 35, the bottoms of the switches 41' to 43' are released to complete the switches.

In this way, the resistor 10, capacitor 20, and coil 30 can be connected serially through the switches 41' to 43'. The point of formation of a large number of RCL series circuits in a planar (two-dimensional) form is the same as in the first embodiment. It is also possible to select the on/off states of the switches to form a desired circuit.

The present embodiment requires transistor switches for driving the electrostatic switches, so has the increased step of providing electrostatic switches compared with the first embodiment, but in addition to the advantage of stabilization of the circuit characteristics by using electrostatic switches, there are the following advantages in the production of static circuit or dynamic circuit MEMS devices.

That is, when using the MEMS array of the present embodiment to form an actual circuit and producing a MEMS device comprised of a static circuit with switches which are constantly on or off, since the switches are formed on the topmost layer, instead of a final step of production of forming the switches, it is sufficient to employ a step of forming an interconnect layer. In this regard, this is easier to produce than the first embodiment. If omitting the switch driving transistors and switch driving electrodes and stocking the devices in the state before forming the interconnect layers, costs can be lowered and delivery times shortened.

Further, when producing as a MEMS device a dynamic circuit leaving some of the switches, by leaving the necessary switches as they are, while, for the part of the switches which will be constantly on or off, for example, selecting the etching locations of the passivation film when etching the switch connections shown in FIG. 32, it is possible to form short-circuited or open circuits. This is again easier compared with the first embodiment. Since the structure is completely the same as the MEMS array before forming the switches, there is no need for a warehouse exclusively for MEMS devices and costs can therefore be lowered.

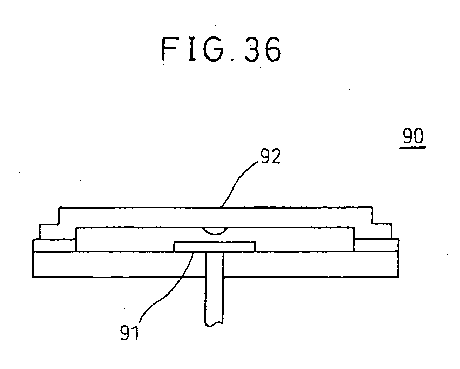

Note that in the case of this embodiment, as the switches, electrostatic switches provided with cantilever type movable electrodes and turning on by attraction by electrostatic force were used, but it is also possible to use electrostatic switches 90 shown in FIG. 36. These are ones where drive electrodes 91 are supplied with voltage and thereby movable electrodes 92 are attracted by electrostatic force and short-circuited so as to turn off. Further, it is also possible to employ suitable switches other than these.

Further, the electrostatic switches were arranged above the interconnect layer, but may also be provided in an interconnect layer.

Further, in both the first and second embodiments, the plurality of elements may also be arranged three-dimensionally and may also be arranged randomly.

The substrate of the MEMS array of the present invention may also carry other semiconductor circuits for signal processing. Further, the semiconductor circuits arranged on the semiconductor substrate may be made three-dimensional in structure as well. Further, the same package where the MEMS device is housed may also house a microprocessor, flash memory, EEPROM, or other semiconductor circuit or device suitable for signal processing to obtain a final product. By adding such other semiconductor circuits or devices, the freedom of circuit configuration is enhanced and a desired high performance MEMS device can be obtained.

As explained above, the freely connectable MEMS array of the present invention is programmable and has general applicability, so no special mask or special process is required. By just designating the connection states, a desired MEMS device can be developed at a low cost. Changes to the prototype are also possible by just resetting the on/off states of the switches. Further, the on/off parts of the switches can be replaced by short-circuit/open states of interconnects, so shortening of the delivery and reduction of the power consumption in semicustom made products become possible. Further, if testing the MEMS array in advance, since the circuits are almost the same, the tests after production of the MEMS devices will almost never find that the specifications are not met and the certification time of devices can therefore be shortened.

## Claims

1. A MEMS array **characterized by** being provided with a plurality of elements and switches for connecting said elements and by enabling the elements to be freely interconnected.

2. A MEMS array as set forth in claim 1, wherein the switches connecting the elements are semiconductor switches.

3. A MEMS array as set forth in claim 1, wherein the switches connecting the elements are mechanical switches.

4. A MEMS array as set forth in claim 1, provided with a substrate and an interconnect layer, said substrate being formed with said switches, said interconnect layer provided with a plurality of elements connected through said switches.

5. A MEMS array as set forth in claim 4, wherein said substrate is provided with drive parts for driving said switches.

6. A MEMS array as set forth in claim 5, wherein said substrate is further provided with semiconductor circuits for signal processing.

7. A MEMS array as set forth in claim 6, wherein said semiconductor circuits have three-dimensional structures.

8. A MEMS array as set forth in claim 1, provided with a substrate and interconnect layer, said interconnect layer provided with a plurality of elements and switches for connecting the elements.

9. A MEMS array as set forth in claim 8, wherein said substrate is provided with drive parts for driving said switches.

10. A MEMS array as set forth in claim 9, wherein said substrate is provided with semiconductor circuits for signal processing.

11. A MEMS array as set forth in claim 10, wherein said semiconductor circuits have three-dimensional structures.

12. A MEMS array as set forth in claim 1, provided with a substrate and interconnect layer, said interconnect layer provided with a plurality of elements, switches for connecting said elements being provided on the interconnect layer.

13. A MEMS array as set forth in claim 12, wherein said substrate is provided with drive parts for driving said switches.

14. A MEMS array as set forth in claim 13, wherein said substrate is provided with semiconductor circuits for signal processing.

15. A MEMS array as set forth in claim 14, wherein said semiconductor circuits have three-dimensional structures.

16. A MEMS array as set forth in claim 1, wherein the same package packages semiconductor circuits built in.

17. A method of production of a MEMS array providing an interconnect layer on a substrate,
said method of production of a MEMS array **characterized by** having:
a step of forming a plurality of switches in said substrate and
a step of forming a plurality of elements connected through said plurality of switches in said interconnect layer.

18. A method of production of a MEMS array providing an interconnect layer on a substrate,
said method of production of a MEMS array **characterized by** having:
a step of forming a plurality of elements in said interconnect layer and
a step of providing a plurality of switches for connecting said plurality of elements on said interconnect layer.

19. A method of production of a MEMS array providing an interconnect layer on a substrate,
said method of production of a MEMS array **characterized by** having:
a step of forming switch drive parts on said substrate,
a step of forming a plurality of elements in said interconnect layer, and
a step of providing a plurality of switches for connecting said plurality of elements on said interconnect layer.

20. A method of production of a MEMS device having a plurality of elements of the same arrangement as a MEMS array provided with a plurality of elements and switches for connecting said elements,
said method of production of a MEMS device **characterized by** having:
a step of determining connection states of switches of said MEMS array and
a step of forming an interconnect layer connecting elements in accordance with the connection states of said switches.

21. A method of production of a MEMS device having a plurality of elements of the same arrangement as a MEMS array provided with a plurality of elements and switches for connecting said elements,
said method of production of a MEMS device **characterized by** having:
a step of determining connection states of switches of said MEMS array,
a step of forming an interconnect layer connecting elements in accordance with the connection states of said switches on the substrate of said MEMS device, and
a step of forming a plurality of elements of the same arrangement as the MEMS array on said interconnect layer.

22. A method of production of a MEMS device having a plurality of elements of the same arrangement as a MEMS array provided with a plurality of elements and switches for connecting said elements,
said method of production of a MEMS device **characterized by** having:
a step of determining connection states of switches of said MEMS array,
a step of providing switches in the substrate of the MEMS device,
a step of providing an additional interconnect layer for short-circuiting, opening, or connecting said switches in accordance with the connection states of said switches on the substrate of the MEMS device, and
a step of providing an interconnect layer arranging a plurality of elements of the same arrangement as said MEMS array on said additional interconnect layer.

23. A method of production of a MEMS device having a plurality of elements of the same arrangement as a MEMS array provided with a plurality of elements and switches for connecting said elements,
said method of production of a MEMS device **characterized by** having:
a step of determining connection states of switches of said MEMS array,
a step of forming an interconnect layer providing a plurality of elements of the same arrangement as said MEMS array, and
a step of selectively forming switches and interconnects on said interconnect layer based on the connection states of said switches.
